# DEMANDE DE BREVET EUROPEEN

(11) **EP 3 012 427 A1**
(43) Date de publication de la demande: **27.04.2016**
(21) Numéro de dépôt: 15188287.5
(22) Date de dépôt: 05.10.2015
(51) Int. Cl.: F01N 5/02, F01N 13/18

(54) **ELÉMENT, ENSEMBLE ET MODULE THERMO ÉLECTRIQUE, NOTAMMENT DESTINÉS À GÉNÉRER UN COURANT ÉLECTRIQUE DANS UN VÉHICULE AUTOMOBILE**

(30) Priorité: 24.10.2014 FR 1460276
(71) Demandeur: Valeo Systemes Thermiques, 78321 Le Mesnil-Saint-Denis (FR); Simonin, Michel, 78960 Voisins le Bretonneux (FR)
(72) Inventeur: SIMONIN, Michel, 78960 Voisins-Le-Bretonneux (FR); DE VAULX, Cédric, 78770 AUTOUILLET (FR)
(74) Mandataire: Gevers & Orès

(57) **Abrégé**

L'invention concerne un élément thermo électrique (3) comprenant au moins une ouverture (10) et un ensemble d'orifices (11, 12), l'ouverture (10) étant configurée pour être en relation thermique avec une source chaude et les orifices (11, 12) étant configuré pour être en relation thermique avec une source froide de température inférieure à celle de la source chaude, ledit élément thermo électrique (3) étant configuré pour générer un courant électrique sous l'action d'un gradient de température exercé entre l'ouverture (10) et les orifices (11, 12) par la source chaude et la source froide.

L'invention concerne aussi un module thermo électrique comprenant au moins un élément thermo électrique.

## Description

La présente invention concerne un élément thermo électrique, un ensemble comprenant ledit élément thermo électrique et un module thermo électrique, notamment destinés à générer un courant électrique dans un véhicule automobile.

Dans le domaine automobile, il a déjà été proposé des modules thermo électriques utilisant des éléments, dits thermo électriques, permettant de générer un courant électrique en présence d'un gradient de température entre deux de leurs faces opposées selon le phénomène connu sous le nom d'effet Seebeck.

Des tels modules sont particulièrement intéressants car ils permettent de produire de l'électricité à partir d'une conversion de la chaleur provenant des gaz d'échappement du moteur. Ils offrent ainsi la possibilité de réduire la consommation en carburant du véhicule en venant se substituer, au moins partiellement, à l'alternateur habituellement prévu dans celui-ci pour générer de l'électricité à partir d'une courroie entrainée par le vilebrequin du moteur.

Ces modules ont une structure dans laquelle les fluides chauds et froids circulent dans des tubes positionnés au contact des éléments thermo électriques de manière à ce qu'un gradient thermique s'établisse entre les faces opposées des élément thermo électriques générant ainsi un courant électrique dans le module. Compte-tenu des sections de passage à offrir aux fluides, les modules connus présentent un encombrement bien supérieur à celui des seuls éléments thermo électriques.

L'invention se propose d'améliorer la situation et concerne à cet effet un élément thermo électrique comprenant au moins une ouverture et un ensemble d'orifices, l'ouverture étant configurée pour être en relation thermique avec une source chaude et les orifices étant configurés pour être en relation thermique avec une source froide de température inférieure à celle de la source chaude, ledit élément thermo électrique étant configuré pour générer un courant électrique sous l'action d'un gradient de température exercé entre l'ouverture et les orifices par la source chaude et la source froide.

L'élément thermo électrique conforme à l'invention est configuré, grâce à son ouverture et ses orifices, pour accueillir en son sein des circuits permettant l'échange de chaleur avec les sources froide et chaude. L'élément thermo électrique permet ainsi de former avec les circuits un ensemble intégré facilitant en outre un pré-assemblage des modules thermo électriques qu'il équipe.

Selon différents modes de réalisation de l'invention qui pourront être pris ensemble ou séparément :
- l'ouverture et les orifices sont traversants ;
- l'ouverture et les orifices présentent chacun une section d'ouverture de contour fermé ;
- ladite section d'ouverture de l'ouverture est plus grande que la somme des sections d'ouverture de chacun des orifices ;
- l'ouverture et les orifices sont circulaires ;
- l'élément thermo électrique est cylindrique ;
- l'élément thermoélectrique est ovoïde ;
- les orifices sont situés autour de l'ouverture ;
- l'ouverture est centrée par rapport à une périphérie de l'élément thermo électrique ;
- les orifices sont répartis sur une périphérie de l'élément thermo électrique ;
- les orifices sont répartis régulièrement autour de l'ouverture ;
- la source chaude est un fluide chaud ;
- la source froide est un fluide froid.

L'invention concerne aussi un ensemble comprenant un élément thermo électrique tel que défini précédemment et deux circuits de circulation d'un fluide chaud de la source chaude, dits premier et deuxième circuits, le premier circuit étant en contact avec l'élément thermo électrique et le deuxième circuit étant situé à l'intérieur du premier circuit.

Ainsi, grâce à l'invention, il est possible de diriger plus ou moins de fluide chaud vers le premier et/ou le deuxième circuit de sorte que l'élément thermo électrique intègre dans son encombrement une fonction de déviation, dite fonction by-pass, permettant au fluide chaud circulant dans le module thermo électrique comprenant un tel ensemble d'échanger plus ou moins de chaleur avec l'élément thermo électrique.

Selon un exemple de réalisation de l'invention, le premier circuit comprend un premier tube et le deuxième circuit comprend un deuxième tube, le deuxième tube étant situé à l'intérieur du premier tube.

Selon un aspect de l'invention, l'ensemble comprend des turbulateurs en contact avec le premier et le deuxième tubes.

L'invention concerne en outre un module thermo électrique comprenant au moins un élément thermo électrique tel que défini précédemment.

Selon un exemple de réalisation de l'invention, ledit module thermo électrique comprend des tubulures de circulation d'un fluide froid de la source froide en relation d'échange thermique avec chacun des orifices.

Selon un aspect de l'invention, ledit module thermo électrique comprend deux circuits de circulation d'un fluide chaud de la source chaude, dits premier et deuxième circuits, le premier circuit étant en contact avec l'élément thermo électrique et le deuxième circuit étant situé à l'intérieur du premier circuit.

Avantageusement, le premier circuit comprend un premier tube et le deuxième circuit comprend un deuxième tube, le deuxième tube étant situé à l'intérieur du premier tube.

De manière avantageuse, le module thermo électrique comprend une vanne by-pass configurée pour répartir le fluide chaud entre le premier et le deuxième circuit.

Selon un aspect de l'invention, les éléments thermo électriques sont empilés selon une direction d'empilement de sorte que chacune des ouvertures et chacun des orifices sont respectivement disposés en vis-à-vis.

L'invention sera mieux comprise à la lumière de la description suivante qui n'est donnée qu'à titre indicatif et qui n'a pas pour but de la limiter, accompagnée des dessins joints parmi lesquels :
- La figure 1 illustre schématiquement en vue de face un exemple de réalisation d'un ensemble comprenant un élément thermo électrique conforme à l'invention ;
- La figure 2 illustre en perspective éclatée les composants d'un module thermo électrique conforme à l'invention en cours de montage ;
- La figure 3 illustre en perspective un exemple de réalisation d'un module thermo électrique conforme à l'invention.

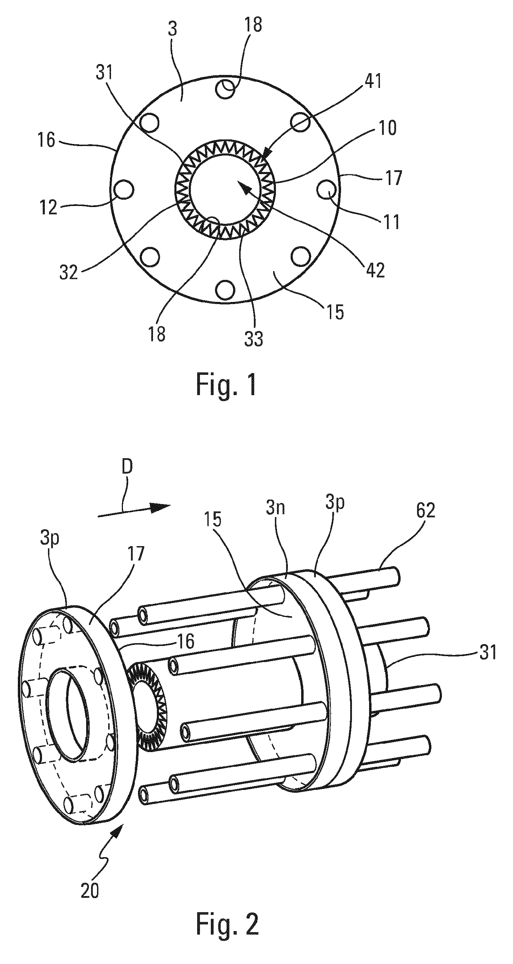

Un ensemble conforme à l'invention est illustré sur la figure 1. Un tel ensemble comprend un élément thermo électrique 3 apte à exploiter la différence de température entre un premier fluide, dit chaud, notamment des gaz d'échappement d'un moteur, et un second fluide, dit froid, notamment un liquide caloporteur d'un circuit de refroidissement, de température inférieure à celle du premier fluide. Le second fluide présente donc ici un coefficient d'échange thermique supérieur audit premier fluide.

Selon l'invention, l'élément thermo électrique 3 comprend au moins une ouverture 10 et un ensemble d'orifices 11, 12 comprenant ici huit orifices 11, 12. L'ouverture 10 est configurée pour être en relation thermique avec le fluide chaud et les orifices 11, 12 sont configurés pour être en relation thermique avec le fluide froid. L'élément thermo électrique 3 est configuré pour générer un courant électrique sous l'action du gradient de température exercé par le fluide chaud et le fluide froid entre l'ouverture 10 et les orifices 11, 12.

L'ensemble comprend en outre deux circuits 41, 42 de circulation du fluide chaud de la source chaude, indépendant entre eux, dits premier 41 et deuxième 42 circuits, le premier circuit 41 étant en contact avec l'élément thermo électrique 3 et le deuxième circuit 42 étant situé à l'intérieur du premier circuit 41. Le premier circuit 41 comprend un premier tube 31 et le deuxième circuit 42 comprend un deuxième tube 32, le deuxième tube 32 étant situé à l'intérieur du premier tube 31. L'ensemble comprend des turbulateurs 33 en contact avec le premier 31 et le deuxième 32 tubes et permettant notamment d'améliorer l'échange thermique entre le fluide chaud et le premier tube 31.

Le deuxième circuit 42 donne une fonction by-pass au module conforme à l'invention, ceci en restant à l'intérieur de l'élément thermo électrique. On permet de la sorte au fluide chaud d'échanger un maximum de chaleur avec l'élément thermo électrique en passant par le premier circuit ou d'en échanger bien moins en passant par le deuxième circuit. Il n'est donc pas nécessaire de prévoir un circuit externe supplémentaire au module thermo électrique comprenant de tels éléments thermo électriques dans le but de réaliser cette fonction by-pass.

De tels éléments fonctionnent, selon l'effet Seebeck, en permettant de créer un courant électrique dans une charge connectée entre l'ouverture 10 et les orifices 11, 12 soumises au gradient de température.

L'ouverture 10 et les orifices 11, 12 sont ici traversants de sorte qu'ils peuvent recevoir, en plus des tubes 31, 32, des tubulures de circulation de fluide comme nous le verrons dans la suite de la description. L'ouverture 10 et les orifices 11, 12 sont avantageusement de contour fermé, notamment circulaire. Ils définissent des faces internes 18 de l'élément thermo électrique 3 avec lesquels l'échange de chaleur se fait, il s'agit des faces actives de l'élément thermo électrique. On comprend ici que l'échange de chaleur entre le fluide chaud et l'élément thermo électrique 3 s'effectue au niveau de la face interne 18 de l'ouverture 10 et l'échange de chaleur entre le fluide froid et l'élément thermo électrique 3 s'effectue au niveau de la face interne 18 des orifices 11, 12. Le gradient de température permettant à l'élément thermo électrique 3 de générer un courant électrique est donc créé entre la face interne 18 de l'ouverture 10 et la face interne 18 des orifices 11, 12.

Dans le mode de réalisation de l'élément thermo électrique 3 illustré sur la figure 1, l'élément thermo électrique 3 est cylindrique et circulaire. Selon un mode de réalisation non représenté, l'élément thermoélectrique est ovoïde. Il comprend une première et une deuxième grandes faces planes 15, 16, en parallèles, et dans lesquelles se trouvent l'ouverture 10 et les orifices 11, 12. Lorsque l'ouverture 10 et les orifices 11, 12 sont traversants, ils traversent l'élément thermo électrique 3 de sa première grande face plane jusqu'à sa deuxième grande face plane. L'élément thermo électrique 3 comprend également une face latérale 17, définissant l'épaisseur de l'élément thermo électrique 3. Autrement dit, la face latérale 17 définit une périphérie de l'élément thermo électrique 3 reliant entre elles les deux grandes faces planes 15, 16. La face latérale 17 est donc ici circulaire.

L'ouverture 10 et les orifices 11, 12 présentent chacun une section d'ouverture. La section d'ouverture de chacun des orifices 11, 12 est par exemple identique entre elles. La section d'ouverture de l'ouverture 10 est notamment plus grande que chacune des sections d'ouverture des orifices 11, 12 et en particulier plus grande que la somme de chacune des sections d'ouverture des orifices 11, 12. On favorise ainsi l'échange entre les éléments thermo électriques 3 et le fluide présentant le coefficient d'échange thermique le plus faible, c'est-à-dire le fluide chaud, ici, les gaz d'échappement.

L'ouverture 10 est ici centrée par rapport à une périphérie de l'élément thermo électrique 3. Les orifices 11, 12 sont notamment répartis sur la périphérie de l'élément thermo électrique. Ils sont situés ici autour de l'ouverture 10 et en particulier de manière régulière autour de l'ouverture 10.

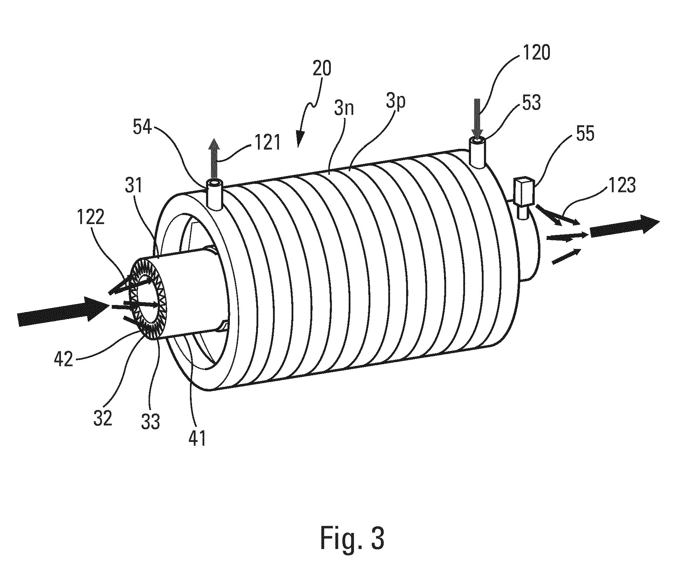

Comme illustré aux figures 2 et 3, l'invention concerne aussi un module thermo électrique 20 comprenant une pluralités d'éléments thermo électriques 3 tels que décrits précédemment.

Les éléments thermo électriques 3 sont ici selon une direction d'empilement D de sorte que chacune des ouvertures 10 et chacun des orifices 11, 12 sont disposés en vis-à-vis. Autrement dit, les ouvertures 10 sont coaxiales entre elles et les orifices 11, 12 sont coaxiaux entre eux. Les éléments thermo électriques 3, sont situés de tel sorte que la première grande face 15 d'un élément thermo électrique est en vis-à-vis de la deuxième grande face 16 d'un élément thermo électrique adjacent et inversement.

Les éléments thermo électriques pourront être, pour une première partie, des éléments 3p d'un premier type, dit P, permettant d'établir une différence de potentiel électrique dans un sens, dit positif, lorsqu'ils sont soumis à un gradient de température donné, et, pour l'autre partie, des éléments 3n d'un second type, dit N, permettant la création d'une différence de potentiel électrique dans un sens opposé, dit négatif, lorsqu'ils sont soumis au même gradient de température.

De façon connue de l'homme du métier, de tels éléments thermo électriques sont constitués, par exemple, de Tellurures, de formule générale (Bi,Sb)2Te3 pour le type N et Bi1-xSbxTe3 pour le type P ou encore de Siliciures, de formule générale Mg2(Si,Ge)xSn1-x pour le type N et MnSix pour le type P ou enfin de Skutterudites de formule générale CoSb3 pour le type N et FeSb3 pour le type P.

Lesdits éléments thermo électriques 3 sont disposés de sorte que les éléments thermo électriques de type P alternent avec les éléments thermo électriques de type N, selon la direction D d'empilement des éléments thermo électriques. Ils sont, notamment, de forme et de dimension identiques. Ils pourront cependant présenter une épaisseur, c'est-à-dire une dimension entre leurs deux faces grandes faces, différente d'un type à l'autre, notamment en fonction de leur conductivité électrique.

Lesdits éléments thermo électriques 3 sont, par exemple, groupés par paire, chaque paire étant formée d'un dit élément thermo électrique de type P et d'un dit élément thermo électrique de type N et ledit module 20 est configuré pour permettre une circulation de courant entre les éléments thermo électriques d'une même paire et une circulation de courant entre les éléments thermo électriques voisins appartenant à des paires adjacentes. On assure de la sorte une circulation en série du courant électrique entre les éléments thermo électriques 3 disposés les uns à côtés des autres selon la direction d'empilement D.

Le module thermo électrique 20 comprend des tubulures 62 de circulation de fluide en relation d'échange de fluide avec les orifices 11, 12. Il s'agit donc de tubulures de circulation du fluide froid. Ces tubulures 62 traversent ici les orifices 11, 12. Ainsi, une fois que les tubulures 62 sont montées dans les éléments thermo électriques par l'intermédiaire des orifices 11, 12, elles forment avec les éléments thermo électriques une structure pré-assemblée, facilitant la solidarisation des éléments thermo électriques aux tubulures.

Pour solidariser les éléments thermo électriques aux tubulures et minimiser les résistances thermiques entre eux il est possible de réaliser leur solidarisation par brasage, gonflage des tubes et tubulures ou simple collage. Autrement dit, les tubes 31, 32 et les tubulures 62 sont par exemple brasés aux éléments thermo électriques 3 du module thermo électrique 20. Selon une variante de l'invention, ils sont expansés dans les éléments thermo électriques 3 du module thermo électrique 20. Selon une autre variante de l'invention, ils sont collés aux éléments thermo électriques 3 du module thermo électrique 20.

Une fois assemblé, le module tel qu'illustré à la figure 3 comprend en outre une boite collectrice d'entrée 53 du fluide froid destinée à guider le fluide froid à l'intérieur des tubulures et une boite collectrice de sortie 54 du fluide froid guidant le fluide froid à l'extérieur du module thermo électrique après avoir traversée les modules thermo électriques 20. Le fluide froid entre dans la boite collectrice d'entrée 53 selon la direction référencée 120 et sort de la boite collectrice de sortie 54 selon la direction référencée 121. On peut remarquer que, grâce à l'invention, les éléments thermo électriques 3 et les tubes 31, 32 ou tubulures 62, sont maintenus ensemble indépendamment de la présence des boites collectrice d'entrée 53 et de sortie 54.

Le module thermo électrique comprend une vanne by-pass 55 configurée pour répartir le fluide chaud entre le premier 41 et le deuxième 42 circuit. Elle permet de répartir les gaz d'échappement lorsque la température est trop haute ou/et la perte de charge trop importante.

Sur l'exemple de réalisation illustré à la figure 3, la vanne by-pass 55 est fermée, c'est-à-dire que l'ensemble du fluide chaud est dirigé dans le premier circuit 41 selon les directions référencées 122, traverse le module thermo électrique et en sort selon les directions référencées 123.

Lorsque la vanne by-pass 55 est ouverte, le fluide chaud se répartit entre le premier 41 et le deuxième circuit 42, c'est-à-dire dans le premier tube 31 et dans le deuxième tube 32.

## Revendications

1. Elément thermo électrique (3) comprenant au moins une ouverture (10) et un ensemble d'orifices (11, 12), l'ouverture (10) étant configurée pour être en relation thermique avec une source chaude et les orifices (11, 12) étant configurés pour être en relation thermique avec une source froide de température inférieure à celle de la source chaude, ledit élément thermo électrique (3) étant configuré pour générer un courant électrique sous l'action d'un gradient de température exercé entre l'ouverture (10) et les orifices (11, 12) par la source chaude et la source froide.

2. Elément thermo électrique (3) selon la revendication 1, dans lequel l'ouverture (10) et les orifices (11, 12) sont traversants.

3. Eléments thermo électrique (3) selon la revendication 1 ou 2, dans lequel l'ouverture (10) et les orifices (11, 12) présentent chacun une section d'ouverture de contour fermé, ladite section d'ouverture de l'ouverture (10) étant plus grande que la somme des sections d'ouverture de chacun des orifices (11, 12).

4. Elément thermo électrique (3) selon l'une quelconque des revendications précédentes, dans lequel l'ouverture (10) et les orifices (11, 12) sont circulaires.

5. Elément thermo électrique (3) selon l'une quelconque des revendications 1 à 4, dans lequel l'élément thermo électrique (3) est cylindrique.

6. Elément thermo électrique (3) selon l'une quelconque des revendications précédentes, dans lequel les orifices (11, 12) sont situés autour de l'ouverture (10).

7. Elément thermo électrique (3) selon la revendication 6, dans lequel les orifices (11, 12) sont répartis régulièrement autour de l'ouverture (10).

8. Elément thermo électrique (3) selon l'une quelconque des revendications précédentes, dans lequel l'ouverture (10) est centrée par rapport à une périphérie de l'élément thermo électrique (3).

9. Elément thermo électrique (3) selon l'une quelconque des revendications précédentes, dans lequel les orifices (11, 12) sont répartis sur une périphérie de l'élément thermo électrique (3).

10. Module thermo électrique (20) comprenant au moins un élément thermo électriques (3) selon l'une quelconque des revendications 1 à 9.

11. Module thermo électrique (20) selon la revendication 10, dans lequel ledit module thermo électrique (20) comprend des tubulures (62) de circulation d'un fluide froid de la source froide en relation d'échange thermique avec chacun des orifices (11, 12).

12. Module thermo électrique (20) selon la revendication 10 ou 11, dans lequel ledit module thermo électrique (20) comprend deux circuits (41, 42) de circulation d'un fluide chaud de la source chaude, dits premier (41) et deuxième (42) circuits, le premier circuit (41) étant en contact avec l'élément thermo électrique (3) et le deuxième circuit (42) étant situé à l'intérieur du premier circuit (41).

13. Module thermo électrique (20) selon la revendication 12, dans lequel le premier circuit (41) comprend un premier tube (31) et le deuxième circuit (42) comprend un deuxième tube (32), le deuxième tube (32) étant situé à l'intérieur du premier tube (31).

14. Module thermo électrique (20) selon la revendication 12 ou 13, dans lequel le module thermo électrique (20) comprend une vanne by-pass (55) configurée pour répartir le fluide chaud entre le premier et le deuxième circuit (41, 42).

15. Module thermo électrique (20) selon l'une quelconque des revendications 10 à 14, dans lequel les éléments thermo électriques (3) sont empilés selon une direction d'empilement de sorte que chacune des ouvertures (10) et chacun des orifices (11, 12) sont respectivement disposés en vis-à-vis.
